# FASCICULE DE BREVET EUROPEEN

(11) **EP 3 126 783 B1**
(45) Date de publication et mention de la délivrance du brevet: **06.05.2020**
(21) Numéro de dépôt: 15719789.8
(22) Date de dépôt: 27.03.2015
(51) Int. Cl.: G01D 3/02, H01R 13/66

(54) **DISPOSITIF DE MESURE D'AU MOINS UNE GRANDEUR PHYSIQUE D'UNE INSTALLATION ELECTRIQUE**
VORRICHTUNG ZUR MESSUNG VON MINDESTENS EINER PHYSIKALISCHEN GRÖSSE EINER ELEKTRISCHEN INSTALLATION
DEVICE FOR MEASURING AT LEAST ONE PHYSICAL QUANTITY OF AN ELECTRIC INSTALLATION

(30) Priorité: 01.04.2014 FR 1452853
(43) Date de publication de la demande: 08.02.2017
(73) Titulaire: Socomec S.A., 67230 Benfeld (FR)
(72) Inventeur: KERN, Christian, F-68240 Sigolsheim (FR)
(74) Mandataire: Koelbel, Caroline
(86) Numéro de dépôt international: PCT/FR2015/050793
(87) Numéro de publication internationale: WO 2015/150671

(56) Documents cités:
- EP-A2- 0 324 067
- US-A- 5 218 298
- US-A- 5 839 094
- US-A1- 2004 034 658
- US-A1- 2014 022 082

## Description

### Domaine technique :

La présente invention concerne un dispositif de mesure d'au moins une grandeur physique d'une installation électrique, comportant au moins un capteur agencé pour mesurer au moins ladite grandeur physique et délivrer au moins un signal représentatif de ladite grandeur physique, et au moins une unité de mesure agencée pour recevoir ledit signal et le traiter pour délivrer au moins une valeur de mesure exploitable, ledit capteur et ladite unité de mesure étant connectés entre eux par au moins un câble de connexion, ledit câble de connexion comportant au moins trois paires de conducteurs, dont une première paire de conducteurs, appelée paire de mesure, agencée pour transmettre ledit signal représentatif de ladite grandeur physique mesurée par ledit capteur, une deuxième paire de conducteurs, appelée paire d'alimentation, agencée pour alimenter électriquement ledit capteur par ladite unité de mesure, et une troisième paire de conducteurs, appelée paire de communication, agencée pour transmettre au moins un signal complémentaire entre ledit capteur et ladite unité de mesure, et ledit capteur comportant des moyens d'encodage **agencés** pour caractériser ledit capteur et transmettre à ladite unité de mesure via ladite paire de communication au moins un signal complémentaire correspondant à au moins une caractéristique d'identification dudit capteur.

### Technique antérieure :

Lors de la mise en place de dispositifs de mesure de puissance sur une installation électrique, la phase de configuration et de vérification de l'installation est souvent source d'erreurs, en particulier sur les réseaux triphasés. En effet, cette mise en place nécessite de placer des capteurs de courant et/ou de tension sur les conducteurs ou phases de l'installation électrique et de raccorder ces capteurs à des unités de mesure qui peuvent être déportées. Par conséquent, les erreurs commises dans cette phase d'installation sont principalement dues à un mauvais branchement des voies de mesure de courant et des voies de mesure de tension entre les capteurs et les unités de mesure, à un calibre de capteur déclaré erroné, à une inversion de polarité des capteurs de courant, etc. Ces erreurs sont parfois difficiles à corriger et peuvent même, dans certains cas, passer inaperçues pendant un certain temps, ce qui peut conduire à des valeurs de mesure fausses et par conséquent à des décisions erronées dans la gestion de l'installation électrique.

Par ailleurs, les dispositifs de mesure de puissance sont de plus en plus précis tout en restant raisonnables en termes de coût. A l'inverse, les capteurs de courant de précision restent chers, car ils sont basés sur des matériaux magnétiques coûteux et volumineux. En associant des données de calibration précises à des capteurs de courant simples, qui sont des capteurs analogiques, peu chers et intrinsèquement peu précis, il est possible d'obtenir une précision accrue. Toutefois, ces données de calibration doivent être transmises au dispositif de mesure, sinon les valeurs mesurées resteront imprécises. Cette contrainte suppose une certaine complexité du capteur de courant, qui induit forcément un surcoût pas toujours justifié au regard de l'application considérée.

Il existe certains capteurs de courant qui communiquent leurs données de calibration aux dispositifs de mesure auxquels ils sont raccordés. La publication EP 0 324 067 décrit un capteur de mesure pourvu d'un transducteur et d'un module d'évaluation dans lequel sont stockées des données d'identification du capteur. Ces données d'identification sont transmises via des lignes de connexion utilisées normalement pour la mesure et l'alimentation en énergie. Ces données d'identification sont donc superposées aux données de mesure et sont forcément numériques. Le schéma de couplage est relativement complexe et fait appel à une liaison numérique bidirectionnelle utilisant plusieurs signaux distincts. La publication US 2014/0022082 décrit un procédé et un appareil pour identifier et localiser des capteurs de courant. L'équipement de mesure comporte au moins un capteur de courant mesurant le courant sur un conducteur de l'installation électrique, et communiquant avec une unité de base à travers un câble de connexion pourvu de deux paires de conducteurs, une première paire pour la transmission du signal de mesure du courant et une seconde paire pour l'identification du capteur au moyen d'une résistance dont la valeur est choisie en fonction dudit capteur. Cet appareil de mesure est limité à la reconnaissance des capteurs simples analogiques et ses possibilités d'encodage sont très restreintes. La publication US 2004/0034658 correspond au préambule de la revendication 1 et décrit un capteur « Plug and Play » pourvu d'un transducteur effectuant des mesures analogiques et d'une carte électronique de données TEDS contenant les données numériques d'identification dudit capteur. Ce capteur communique avec une unité de mesure à travers une interface de communication en mode mixte analogique/numérique, comportant trois paires de conducteurs, dont une première paire sert à la transmission du signal de mesure analogique, une deuxième paire à l'alimentation du capteur, et une troisième paire à la transmission des données numériques d'identification du capteur. L'unité de mesure ne peut reconnaître que des capteurs pourvus d'un encodage numérique.

D'autres documents pertinents de l'état de la technique sont US5218298A et US5839094A. Enfin, il peut être utile de transmettre des informations complémentaires relatives aux capteurs de courant et/ou de tension vers l'unité de mesure ou inversement pour enrichir les fonctionnalités desdits capteurs, par exemple, des informations de température de ces capteurs pour augmenter la précision des mesures, ou toute autre information complémentaire. En effet, l'information de température peut être utilisée pour effectuer une compensation en fonction de la température mais également pour fournir des informations sur l'environnement du capteur permettant par exemple de générer une alarme en cas de dépassement d'un seuil de température critique.

Or, il n'existe pas à l'heure actuelle dans le domaine de la mesure de puissance d'une installation électrique, de capteurs de courant ou de tension bon marché, fournissant des informations complémentaires aux dispositifs de mesure auxquelles ils sont raccordés. Les dispositifs de mesure utilisent aujourd'hui dans leur très grande majorité des capteurs de courant sous la forme de transformateurs de courant ayant un circuit secondaire en ampère, dont la valeur nominale est de 5A ou 1A, sans capteur auxiliaire intégré. On constate une tendance à aller vers des transformateurs de courant ayant un circuit secondaire en tension, dont la valeur la plus couramment utilisée est de 1/3V. Cette évolution permet de baisser le prix des transformateurs de courant en réduisant la taille des circuits magnétiques, mais n'apporte aucune nouveauté en termes de fonctionnalité. L'utilisateur doit toujours configurer le type de capteur raccordé : capteur de courant ou capteur de tension, ainsi que ses données de calibrage. Il peut toujours se tromper de polarité. Et aucune fonction supplémentaire ne peut être apportée par ce type de capteurs. Pour corriger les erreurs de branchement, on fait appel en général à une analyse de la relation de phase entre courant et tension. Mais cette approche suppose la présence d'un courant significatif et d'une connaissance à priori du facteur de puissance de la charge. Cette correction de branchement ne peut donc pas être effectuée aisément avant la mise en service, alors même que les tableaux électriques sont souvent pré-câblés avant même d'être livrés. Il serait donc avantageux de pouvoir vérifier que l'intégralité du câblage a été correctement réalisée avant la mise en service de l'installation électrique.

Les solutions actuellement disponibles sur le marché ne sont pas totalement satisfaisantes.

### Exposé de l'invention :

La présente invention vise à pallier ces inconvénients en proposant un dispositif de mesure intelligent, modulaire, économique, adapté aussi bien à des capteurs simples analogiques qu'à des capteurs évolués numériques, dans le but d'améliorer la qualité et la précision des mesures sans renchérir le coût des capteurs ou en utilisant des capteurs bon marché, en rendant possible la reconnaissance automatique des capteurs quel que soit leur type par les dispositifs de mesure, permettant de contrôler le bon fonctionnement des capteurs et d'éviter les erreurs de transcription du calibre des capteurs, le type de capteurs, les erreurs de câblage, ainsi que les fraudes par détection de l'absence d'un capteur notamment.

Dans ce but, l'invention concerne un dispositif de mesure selon la revendication indépendente 1.

Si le capteur est analogique, alors il comporte avantageusement deux résistances dont les valeurs de résistance sont choisies en fonction d'au moins une caractéristique d'identification dudit capteur. Dans ce cas, l'unité de mesure comporte deux autres résistances agencées pour former avec les deux résistances dudit capteur, deux ponts diviseurs connectés d'une part à ladite paire d'alimentation et d'autre part à ladite paire de communication pour délivrer aux bornes de ladite paire de communication au moins un signal complémentaire de tension sous forme analogique représentatif de ladite caractéristique d'identification dudit capteur.

Si le capteur est numérique, alors il comporte avantageusement une unité de traitement dans laquelle est enregistrée au moins une caractéristique d'identification dudit capteur, cette unité de traitement étant connectée d'une part à ladite paire d'alimentation et d'autre part à au moins un des conducteurs de la paire de communication pour délivrer au moins un signal complémentaire sous forme numérique représentatif de ladite caractéristique d'identification dudit capteur.

Les moyens d'encodage peuvent être agencés pour transmettre à ladite unité de mesure via ladite paire de communication plusieurs signaux complémentaires correspondant à plusieurs caractéristiques d'identification dudit capteur permettant à ladite unité de mesure de reconnaître ledit capteur, ces caractéristiques d'identification pouvant être choisies dans le groupe comprenant la tension nominale du capteur, le courant nominal du capteur, les données de calibrage du capteur, la courbe de compensation des erreurs de gain du capteur, la courbe de compensation des erreurs de phase du capteur.

Ladite unité de mesure peut comporter en outre deux résistances connectées respectivement entre les conducteurs desdites paires de mesure et d'alimentation pour polariser les conducteurs de ladite paire de mesure et détecter la présence dudit capteur.

La paire de communication peut être agencée pour véhiculer sur l'un de ses conducteurs au moins un premier signal complémentaire représentatif d'au moins une caractéristique d'identification dudit capteur et sur l'autre de ses conducteurs au moins un second signal complémentaire correspondant à une grandeur physique auxiliaire de ladite installation électrique.

D'une manière préférentielle, le capteur est un capteur de courant agencé pour mesurer le courant sur un des conducteurs de ladite installation électrique.

Dans première une variante de réalisation, le dispositif de mesure peut comporter au moins un capteur de tension auxiliaire agencé pour mesurer une valeur de tension auxiliaire représentative de la tension présente sur le conducteur dont on mesure le courant par ledit capteur de courant, cette valeur de tension auxiliaire formant une grandeur physique auxiliaire véhiculée sur un des conducteurs de ladite paire de communication.

Ce capteur de tension auxiliaire peut être intégré audit capteur de courant ou monté en série entre ledit capteur de courant et ladite unité de mesure et connecté à chacun d'eux par au moins un câble de connexion.

Ce capteur de tension auxiliaire peut comporter au moins un sélecteur agencé pour inverser automatiquement le sens du branchement dudit capteur de tension auxiliaire entre ledit capteur de courant et ladite unité de mesure en cas d'erreur de branchement.

Dans une seconde variante de réalisation, le capteur de courant peut comporter au moins un capteur de courant de fuite à la terre à très basse fréquence par rapport à la fréquence du réseau alimentant ladite installation électrique, agencé pour mesurer une valeur de courant de fuite à la terre avec une bande passante incluant au moins la fréquence du réseau d'alimentation, cette valeur de courant de fuite à la terre formant une grandeur physique auxiliaire véhiculée sur un des conducteurs de ladite paire de communication.

Dans une troisième variante de réalisation, le capteur de courant peut comporter au moins un capteur de température agencé pour mesurer la température dudit capteur de courant, cette température formant une grandeur physique auxiliaire véhiculée sur un des conducteurs de ladite paire de communication.

Dans une quatrième variante de réalisation, le capteur de courant peut comporter au moins un capteur de courant additionnel agencé pour effectuer une deuxième mesure de courant sur le conducteur de ladite installation électrique, cette deuxième mesure de courant formant une grandeur physique véhiculée sur un des conducteurs de ladite paire de communication pour vérifier le bon fonctionnement dudit capteur de courant par comparaison de cette deuxième mesure de courant avec celle effectuée par ledit capteur de courant.

De manière préférentielle, l'unité de mesure comporte une unité de traitement contenant au moins une table de correspondances entre des caractéristiques d'identification et des capteurs, et l'unité de traitement est connectée à ladite paire de communication pour recevoir au moins le signal complémentaire représentatif de ladite caractéristique d'identification lui permettant de reconnaître automatiquement le capteur qui est branché à ladite unité de mesure et de délivrer une valeur corrélée exploitable de ladite grandeur physique mesurée.

Le dispositif de mesure comporte avantageusement N capteurs de courant, pourvus chacun d'un capteur de tension auxiliaire, et N capteurs de tension agencés pour mesurer respectivement le courant et la tension sur N conducteurs de ladite installation électrique. Dans ce cas, l'unité de mesure peut comporter un module de corrélation agencé pour mettre en correspondance la mesure de tension qui correspond à la mesure de la tension auxiliaire effectuée sur un même conducteur de ladite installation électrique et pallier automatiquement les éventuelles erreurs de branchement desdits capteurs.

Le but de l'invention est également atteint par l'utilisation du dispositif de mesure décrit précédemment pour détecter une tentative de fraude sur ledit dispositif de mesure par détection d'une incohérence sur les signaux transmis via ledit câble de connexion entre ledit capteur et ladite unité de mesure.

Le but de l'invention est également atteint par l'utilisation du dispositif de mesure pour détecter l'ouverture d'un dispositif de coupure disposé en amont d'une installation électrique si d'une part le capteur de tension est connecté en amont dudit dispositif de coupure et si d'autre part le capteur de courant pourvu de son capteur de tension auxiliaire est connecté en aval dudit dispositif de coupure.

### Description sommaire des dessins :

La présente invention et ses avantages apparaîtront mieux dans la description suivante de plusieurs modes de réalisation donnés à titre d'exemple non limitatif, en référence aux dessins annexés, dans lesquels:
- la figure 1 représente un premier dispositif de mesure selon l'invention pourvu d'un capteur de courant simple avec encodage réalisé par deux résistances disposées dans ledit capteur,
- la figure 2 représente un deuxième dispositif de mesure selon l'invention pourvu d'un capteur de courant évolué sous la forme d'un intégrateur sur une boucle de Rogowski et d'un capteur de tension auxiliaire sous la forme d'une électrode de détection de tension,
- la figure 3 représente un troisième dispositif de mesure selon l'invention pourvu d'un capteur de tension auxiliaire séparé du capteur de courant,
- la figure 4 représente un quatrième dispositif de mesure selon l'invention, similaire à celui de la figure 3, mais comportant un sélecteur pour rendre le capteur de tension auxiliaire réversible,
- la figure 5 représente un dispositif de mesure selon l'invention raccordé à une installation électrique triphasée montrant une erreur de branchement entre les voies de tension et de courant correspondant aux phases L2 et L3, et
- la figure 6 est un diagramme des signaux de tension de l'installation triphasée de la figure 5 et du signal de tension auxiliaire Vaux mesuré par le dispositif de mesure selon l'invention pourvu d'un module de corrélation recherchant automatiquement la voie de tension correspondant le mieux à la tension auxiliaire mesurée.

### Illustrations de l'invention et différentes manières de la réaliser :

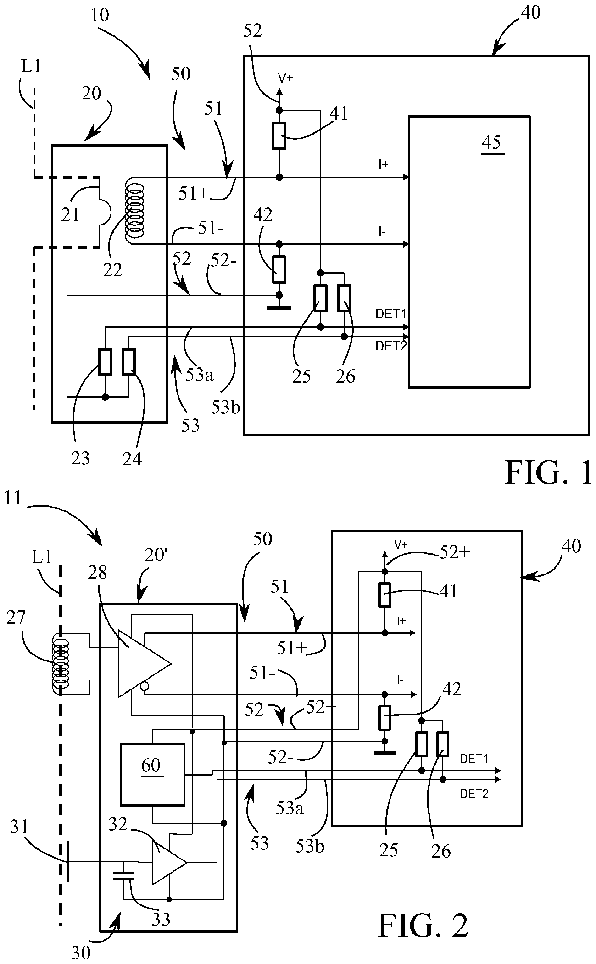

En référence aux figures, le dispositif de mesure 10-13 selon l'invention comporte un capteur 20, 20' agencé pour mesurer au moins une grandeur physique d'une installation électrique et une unité de mesure 40 couplée audit capteur 20, 20' par un câble de connexion 50 particulier. Le capteur est dans l'exemple décrit et illustré un capteur de courant 20, 20' agencé pour mesurer le courant sur un des conducteurs L1 de l'installation électrique, mais peut concerner tout autre type de capteur. Le capteur de courant 20, 20' utilise des technologies existantes, telles qu'un transformateur de courant, une boucle de Rogowski, des capteurs à base de mesure champ magnétique telle que l'effet Hall ou le système « Fluxgate », ou similaire, et délivre un signal représentatif du courant mesuré, ce signal étant généralement de forme analogique. Ce capteur 20, 20' peut être aussi bien un capteur simple analogique, qu'un capteur évolué numérique. L'unité de mesure 40 est conçue pour pouvoir être connectée à tout type de capteur 20, 20' et constitue ainsi un module standard identique pour chacune des configurations illustrées dans les figures. Elle comporte notamment une unité de traitement 45, représentée uniquement sur la figure 1 mais présente dans tous les modes de réalisation selon les figures 2 à 4. Cette unité de traitement 45 est programmable et est agencée pour recevoir le signal provenant dudit capteur de courant 20, 20'. L'unité de traitement 45 permet, en outre, de traiter et d'exploiter le signal afin d'afficher une valeur de mesure exploitable par un opérateur et/ou une centrale de supervision qui peut être déportée, telle qu'une valeur de courant, de puissance, d'énergie, un facteur de puissance, une analyse harmonique des courants et/ou des puissances, etc.

Le câble de connexion 50 utilisé pour connecter le capteur de courant 20, 20' et l'unité de mesure 40 est un câble modulaire qui comporte six positions et six contacts, habituellement connu sous le nom de câble RJ12 ou tout câble similaire. Ce type de câble RJ12, également appelé Registered Jack 12, est un standard international utilisé par des appareils téléphoniques fixes. Il est également utilisé dans le domaine des réseaux locaux. Il présente trois paires de conducteurs 51, 52, 53. Une première paire de conducteurs 51 est utilisée pour la transmission différentielle d'un signal analogique représentatif d'une grandeur à mesurer provenant dudit capteur de courant 20, 20', est appelée par la suite « paire de mesure », et est raccordée à l'unité de traitement 45. Une deuxième paire de conducteurs 52 est utilisée pour l'alimentation du capteur 20, 20' par l'unité de mesure 40, et est appelée par la suite « paire d'alimentation ». Une troisième paire de conducteurs 53 est utilisée pour transmettre des informations complémentaires sous la forme de signaux DET1, DET2 indifféremment analogiques et numériques entre le capteur de courant 20, 20' et l'unité de mesure 40, est appelée par la suite « paire de communication » et est raccordée à l'unité de traitement 45. Bien entendu, tout autre système de connexion comportant au moins trois paires de conducteurs peut être utilisé.

Les conducteurs 51+, 51- de la paire de mesure 51 sont polarisés par l'unité de mesure 40 à l'aide de deux résistances 41, 42 de forte valeur par rapport à la résistance de sortie maximale du capteur de courant 20, 20'. Une première résistance 41 est connectée entre un des conducteurs 51+ de la paire de mesure 51 et le conducteur 52+ de polarité positive de la paire d'alimentation 52, et la seconde résistance 42 est connectée entre le deuxième conducteur 51- de la paire de mesure 51 et le conducteur 52- de polarité négative de la paire d'alimentation 52. Lorsqu'aucun capteur de courant n'est raccordé à l'unité de mesure 40, la tension différentielle sur la paire de mesure 51 est quasi constante et voisine de la tension de la paire d'alimentation 52. Lorsqu'un capteur de courant 20, 20' est raccordé, et du fait de la faible impédance de sortie du capteur de courant 20, 20', la tension différentielle sur la paire de mesure 51 est l'image du signal à mesurer. Etant donné que le dispositif de mesure 10-13 est destiné à la mesure de signaux alternatifs, la mesure de la valeur moyenne de ce signal de tension différentielle permet en conséquence de détecter la présence d'un capteur de courant 20, 20'.

La figure 1 illustre un premier mode de réalisation du dispositif de mesure 10 selon l'invention comportant un capteur de courant 20 simple analogique, dit passif, constitué par un transformateur de courant, dont le circuit primaire 21 est formé par le conducteur L1 de l'installation électrique à contrôler et le circuit secondaire 22 est couplé à la paire de mesure 51. Ce dispositif de mesure 10 comporte des moyens d'encodage 23, 24 et 25, 26 dudit capteur de courant 20 prévus respectivement dans ledit capteur 20 et dans ladite unité de mesure 40. A cet effet, la paire de communication 53 est utilisée pour former deux ponts diviseurs de tension au moyen de deux paires de résistances 23, 24 et 25, 26, présentes respectivement dans le capteur de courant 20 et dans l'unité de mesure 40. Préférentiellement mais non exclusivement, on trouve sur chaque conducteur 53a, 53b de cette paire de communication 53, une résistance 25, 26 située dans l'unité de mesure 40 entre le conducteur 53a, 53b et la polarité positive 52+ de la paire d'alimentation 52, et une résistance 23, 24 située dans le capteur de courant 20 entre le conducteur 53a, 53b et la polarité négative 52- de la paire d'alimentation 52. Plus précisément, le pont diviseur 23, 25 génère un signal de tension DET1, et le pont diviseur 24, 26 génère un signal de tension DET2. En l'absence d'un capteur 20, les signaux DET1 et DET2 prennent la valeur de la tension d'alimentation et, en présence d'un capteur 20, les signaux DET1 et DET2 prennent les valeurs analogiques comprises entre 0 et la tension d'alimentation. Ainsi, la valeur de la tension entre chaque conducteur 53a, 53b et le conducteur 52- de polarité négative ou le conducteur 52+ de polarité positive de la tension d'alimentation dépend de la valeur des résistances 23-26 formant les deux ponts diviseurs de tension et, dans une certaine mesure, de la résistance des conducteurs 53a, 53b de la paire de communication 53. Toutefois, on peut s'affranchir de l'influence des conducteurs 53a, 53b en utilisant pour les résistances 23-26 des valeurs élevées, typiquement de quelques kOhms à quelques dizaines de kOhms, par rapport aux résistances des conducteurs 53a, 53b, typiquement de quelques fractions d'Ohms à quelques dizaines d'Ohms. Cette tension sur les conducteurs 53a, 53b de la paire de communication 53 est convertie en valeur numérique à l'aide d'un convertisseur analogique/numérique (non représenté) intégré dans l'unité de traitement 45 de l'unité de mesure 40. De cette manière, il est possible d'encoder une vingtaine de niveaux de tension sur chacun des deux conducteurs 53a, 53b de la paire de communication 53, soit environ quatre cents valeurs de tension différentes disponibles, offrant ainsi une pluralité de codes permettant de caractériser un capteur de courant 20. Bien entendu, plus on choisit de niveaux différents plus la richesse de codage est grande, mais plus la sensibilité aux perturbations et à la longueur des câbles est élevée. Préférentiellement, ces niveaux de tension sont répartis entre 0V et la tension d'alimentation pour fournir un maximum d'immunité aux perturbations. Cette méthode d'encodage permet d'inclure de manière non exhaustive le calibre nominal du capteur de courant 20 en choisissant la valeur des résistances 23, 24 en fonction dudit calibre. Compte tenu du nombre relativement réduit de calibres à encoder, soit entre dix et trente calibres de capteur de courant utiles pour couvrir les besoins du marché, on peut également utiliser le nombre relativement élevé des possibilités d'encodage pour identifier d'autres informations, comme une courbe de compensation typique des erreurs de gains et de phase par modèle de capteur de courant. On peut imaginer pour un même calibre de capteur de courant, plusieurs technologies de fabrication, en fonction des performances souhaitées. Un transformateur de courant à noyau en Fer/Silicium sera moins cher qu'un transformateur de même calibre à noyau en Fer/Nickel mais sera également moins précis. La courbe de compensation à appliquer n'est donc pas seulement fonction du calibre mais également de la technologie choisie.

L'unité de traitement 45 est programmable et comporte notamment une table de correspondances entre des caractéristiques d'identification et des capteur de courants 20, 20' permettant de faire la corrélation avec les signaux complémentaires DET1, DET2 qu'elle reçoit via la paire de communication 53 lui permettant de reconnaître automatiquement le type de capteur de courant 20, 20' raccordé à ladite unité de mesure 40 et donc de délivrer une valeur corrélée exploitable de la grandeur physique mesurée par ledit capteur de courant 20, 20'.Le convertisseur analogique/numérique (non représenté) intégré dans l'unité de traitement 45 fournit soit une valeur numérique permettant de déterminer le ratio de résistances 23/25 et 24/26 si le capteur 20 est analogique, soit par comparaison à un seuil avec ou sans hystérésis une séquence de valeurs binaires si le capteur 20' est numérique, comporte l'unité de traitement 60 et transmet les données d'identification sous forme de séquence de données binaires.

La figure 2 illustre un deuxième mode de réalisation du dispositif de mesure 11 selon l'invention pourvu d'un capteur de courant 20' évolué numérique, comportant une boucle de Rogowski 27 traversée par le conducteur L1 de l'installation électrique à contrôler, et associée à un intégrateur 28, alimenté par les conducteurs 52+, 52- de la paire d'alimentation 52, et dont les sorties sont connectées aux conducteurs 51+, 51-de la paire de mesure 51 raccordée à l'unité de traitement 45 (non représentée sur cette figure). Dans ce mode de réalisation, un capteur de tension auxiliaire 30 est intégré dans le capteur de courant 20' et agencé pour mesurer une valeur de tension auxiliaire image de la tension du conducteur L1 de l'installation électrique sur lequel le capteur de courant 20, 20' est installé, en utilisant des technologies existantes, telles qu'une mesure capacitive, une mesure de champ électrique, une mesure résistive, ou similaire, et pour délivrer un signal représentatif de la tension mesurée, ce signal étant généralement de forme analogique. Le capteur de tension auxiliaire 30 illustré utilise une mesure capacitive au moyen d'une électrode 31 de détection de tension sans contact disposée à proximité du conducteur L1 de ladite installation, associée à un condensateur 33 connecté au conducteur négatif 52- de la paire d'alimentation 52 et à un amplificateur 32, alimenté par les conducteurs 52+, 52- de la paire d'alimentation 52 et connecté à l'un des conducteurs 53b de la paire de communication 53 pour transmettre un signal DET2 représentatif de la tension mesurée, ce signal étant généralement de forme analogique. Dans cette forme de réalisation, les résistances 23, 24 permettant de caractériser le capteur de courant 20 de l'exemple précédent, sont remplacées par une unité de traitement 60, typiquement un microcontrôleur programmable, alimentée par les conducteurs 52+, 52- de la paire d'alimentation 52. Cette unité de traitement 60 est utilisée pour transmettre sur un des conducteurs 53a de la paire de communication 53 des signaux complémentaires DET1 sous forme numérique correspondant à des caractéristiques d'identification du capteur de courant 20' raccordé à l'unité de mesure 40. Ces caractéristiques d'identification peuvent être des informations sur le calibre nominal, un numéro de série et des données de calibration permettant une compensation précise des erreurs de gain et de phase dues au capteur de courant 20' en tant que tel et non plus par modèle de capteur de courant, comme dans l'exemple précédent. Cette unité de traitement 60 permet également de transmettre des informations complémentaires intéressantes comme la température du capteur de courant 20' et du capteur de tension auxiliaire 30 par exemple. Dans ce cas, il convient d'ajouter dans le capteur de courant 20, 20' un capteur de température.

Lorsque le capteur de courant 20' est constitué d'une boucle de Rogowski 27 associée à son intégrateur 28, comme c'est le cas dans la figure 2, on sait qu'il est très difficile de garantir la précision et la reproductibilité par construction de ce type de capteur de courant, à cause des tolérances mécaniques et des tolérances sur les valeurs des composants. Par contre, on sait également qu'il est relativement aisé de mesurer ces erreurs pour les enregistrer ensuite dans l'unité de traitement 60 du capteur de courant 20' afin d'en tenir compte lors des mesures et de compenser ou corriger des mesures en conséquence.

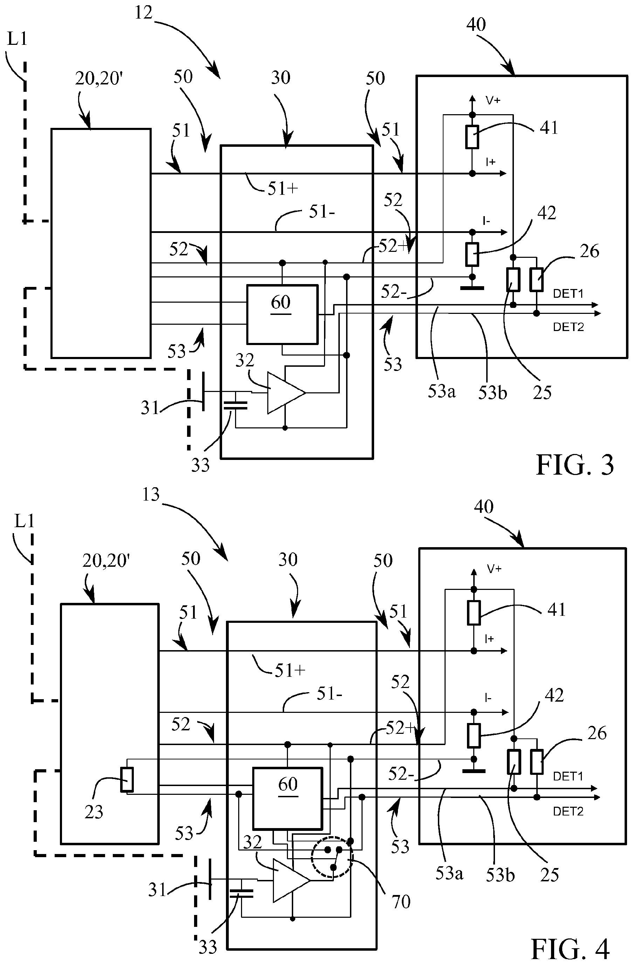

La figure 3 illustre un troisième mode de réalisation du dispositif de mesure 12 selon l'invention pourvu d'un capteur de tension auxiliaire 30 séparé du capteur de courant qui peut être indifféremment un capteur de courant simple analogique 20 selon la figure 1 ou un capteur de courant évolué numérique 20' selon la figure 2. Dans ce cas, le capteur de tension auxiliaire 30 est monté en série entre le capteur de courant 20, 20' et l'unité de mesure 40 au moyen de deux câbles de connexion 50 à six positions.

La figure 4 illustre un quatrième mode de réalisation du dispositif de mesure 13 selon l'invention, similaire à celui de la figure 3, mais comportant un sélecteur 70 pour rendre le capteur de tension auxiliaire 30 réversible automatiquement simplifié le travail de l'opérateur. Le capteur de tension auxiliaire 30 étant raccordé entre le capteur de courant 20, 20' et l'unité de mesure 40, l'opérateur peut se tromper de sens de branchement étant donné que les prises des câbles de connexion 50 sont identiques. L'unité de traitement 60 prévue dans le capteur de tension auxiliaire 30 est agencée pour détecter le sens du branchement et basculer automatiquement le sélecteur 70 pour inverser le sens du branchement en cas d'erreur de raccordement.

Le dispositif de mesure 10-13 tel qu'il vient d'être décrit est polyvalent et doté de fonctions intelligentes. Il est notamment capable de différencier un capteur de courant simple analogique 20, dont l'encodage est effectué par de simples résistances 23 à 26, d'un capteur de courant évolué numérique 20' dont l'encodage est effectué par une unité de traitement 60. Pour ce faire, l'unité de traitement 45 prévue dans l'unité de mesure 40 est agencée pour détecter une activité, par la présence d'un signal binaire DET1, sur le conducteur 53a de la paire de communication 53 supportant éventuellement la transmission numérique dans le cas d'un capteur de courant évolué numérique 20'. Si au bout d'un certain temps, elle ne détecte aucune activité cohérente sur ce conducteur 53a, elle tente d'identifier un capteur de courant simple analogique 20 en fonction des niveaux moyens de tension détectés entre le conducteur 53a de la paire de communication 53 et le conducteur 52- de polarité négative de la paire d'alimentation 52. Si elle ne peut pas mettre en correspondance un capteur de courant simple analogique 20 avec les niveaux moyens de tension détectés, elle relance une recherche d'un capteur de courant évolué numérique 20'.

Lorsque le dispositif de mesure 11-13 comporte un capteur de courant 20' évolué numérique, par exemple selon la figure 2, un des deux conducteurs 53b de la paire de communication 53 est inutilisé. On peut avantageusement et de manière non exhaustive utiliser ce conducteur 53b disponible pour transmettre un signal analogique complémentaire DET2 pouvant être utilisé par l'unité de traitement 45 et permettant d'améliorer sa connaissance de l'environnement du capteur de courant 20', ou utiliser ce conducteur 53b pour transmettre des informations au capteur de courant 20', par exemple pour faire une campagne de mesures en changeant le calibre nominal du capteur de courant 20' s'il offre cette possibilité.

Il est également possible d'utiliser le conducteur 53b de la paire de communication 53 pour véhiculer un signal complémentaire DET2 correspondant à une grandeur physique additionnelle ou auxiliaire de l'installation électrique et se présentant par exemple sous une forme analogique. Comme on l'a vu en référence aux figures 2 à 4, ce signal complémentaire DET2 peut être un signal de tension auxiliaire image de la tension du conducteur L1 de l'installation électrique dont on mesure le courant, comme le permet le capteur de tension auxiliaire 30. Ce signal de tension auxiliaire peut être très imprécis en amplitude étant donné qu'il ne sert pas à mesurer la tension réelle sur le conducteur L1, mais sa forme doit être proche du signal de tension réel et le décalage temporel avec le signal de tension réel doit être relativement faible, de l'ordre de quelques degrés de déphasage par rapport à la fréquence du réseau égal par exemple à 50Hz.

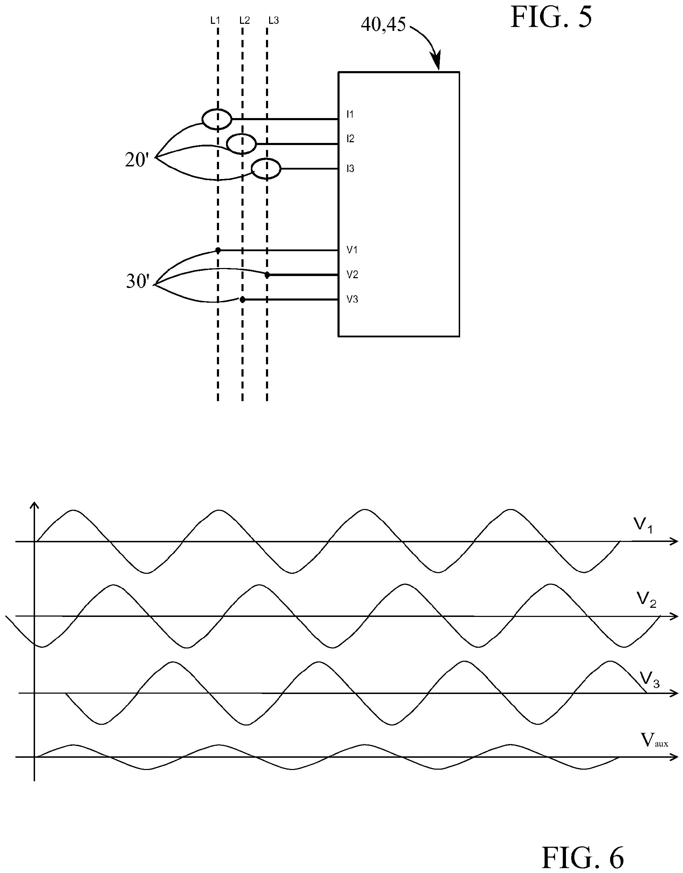

L'unité de traitement 45 de l'unité de mesure 40 peut comporter un module de corrélation permettant de détecter automatiquement quelle est la voie de tension qui correspond au capteur de courant 20' pourvu d'un capteur de tension auxiliaire 30, en recherchant laquelle des tensions nominales V1, V2, V3 connectées à l'unité de traitement 45 présente le maximum de corrélation avec le signal de tension auxiliaire Vaux. La figure 5 illustre un exemple de branchement entre les trois phases L1, L2, L3 de l'installation électrique et les voies de tension V1, V2, V3 d'une part et les voies de courant I1, I2, I3 d'autre part sur l'unité de traitement 45. Dans ce cas, les voies de tension V1, V2, V3 sont couplées à des capteurs de tension 30' par exemple en prise directe pour mesurer la tension réelle sur chacune des phases. Une inversion de branchement a été volontairement introduite entre les phases L2 et L3 sur les voies de tension V2 et V3. Le diagramme de la figure 6 montre à titre d'exemple la corrélation entre le signal auxiliaire Vaux obtenu par le capteur de tension auxiliaire 30 et la voie de tension V1 correspondant à la phase L1 de l'installation sur laquelle le capteur de courant 20' est installé et branché sur la voie I1 de l'unité de traitement 45. Bien entendu, cette méthode de corrélation peut s'effectuer automatiquement sur les autres phases L2 et L3 si les capteurs de courant 20' sont prévus avec un capteur de tension auxiliaire 30.

Dans cette configuration, le signal auxiliaire Vaux, image de la tension sur un des conducteurs L1 sur lequel on mesure l'intensité, peut également être utilisé pour détecter l'ouverture d'un organe de coupure (tel qu'un disjoncteur) ou la fusion d'un fusible pour déclencher une alerte ou similaire, si les capteurs de tension 30' alimentant les voies de tension V1, V2, V3 de l'unité de traitement 45 sont connectés aux phases L1, L2, L3 en amont du dispositif de coupure et si les capteurs de courant 20' comportant un capteur de tension auxiliaire 30 sont connectés en aval dudit dispositif de coupure.

### Possibilités d'application industrielle :

Le dispositif de mesure 10-13 selon l'invention utilise des composants électriques et électroniques disponibles sur le marché. Il est rendu intelligent grâce à l'intégration d'unités de traitement 45, 60 programmables et à une communication indifféremment analogique et numérique entre les capteurs de courant 20, 20' et l'unité de mesure 40 qui constitue un module standardisé. De ce fait, le dispositif de mesure 10-13 est modulaire, polyvalent et s'adapte à tout type de capteurs de courant 20, 20' de manière automatique, et de la même manière à tout autre type de capteurs équivalents. Cette conception ouvre de nouvelles perspectives d'exploitation des grandeurs physiques d'une installation électrique et permet ainsi des applications multiples tendant vers une plus grande sécurité et une meilleure fiabilité des données mesurées.

A titre d'exemple, dans le cadre d'une application de comptage d'énergie, l'utilisation du dispositif de mesure 10-13 selon l'invention rend la fraude particulièrement délicate. En effet, ce dispositif de mesure 10-13 est capable de détecter l'absence d'un capteur de courant grâce aux résistances 41, 42 prévues dans l'unité de mesure 40, le calibre nominal d'un capteur de courant, le remplacement d'un capteur de courant en contrôlant le numéro de série, les incohérences entre les tensions mesurées directement par le dispositif de mesure 40 connecté au(x) capteur de courant(s) 20, 20', ledit dispositif de mesure 40 étant en fait un compteur d'énergie, et celles détectées par le capteur de tension auxiliaire 30, etc.

De même, l'exploitation d'un signal auxiliaire peut permettre également d'améliorer la fiabilité de la recherche de défauts à la terre dans les installations électriques isolées de la terre. Dans ce cas, le capteur de courant comporte un capteur de courant de fuite à la terre. Le signal utile pour mesurer les défauts résistifs à la terre est en général un signal de courant à très basse fréquence, de faible amplitude, qui est souvent superposé à un signal de courant présent sur le conducteur à la fréquence du réseau, d'amplitude beaucoup plus élevée. Pour pouvoir traiter correctement le signal utile à très basse fréquence, on effectue un filtrage passe-bas du signal global afin de pouvoir correctement amplifier le signal de courant à très basse fréquence. Cependant, le signal de courant de fuite à la terre de l'installation à contrôler peut présenter une composante à la fréquence du réseau (50Hz par exemple) qui peut être d'amplitude beaucoup plus forte que la composante à basse fréquence transmise sur la paire de mesure 51. Cette composante à la fréquence du réseau peut fournir des informations intéressantes, en particulier pour vérifier l'absence de saturation du capteur de courant de fuite à la terre et que le capteur de courant de fuite à la terre est bien utilisé dans une gamme de courant compatible avec l'application de recherche de défauts résistifs à la terre. Le conducteur 53b de la paire de communication 53 peut donc être utilisé pour fournir l'image non filtrée du courant de fuite à la terre et pour déclencher le cas échéant une alerte.

Un autre exemple d'exploitation d'un signal auxiliaire peut être un signal fournissant une information sur la même grandeur physique que celle déjà mesurée, par exemple un signal de courant, mais obtenu de manière différente et moins précise par un capteur de courant additionnel bon marché. La comparaison des deux signaux représentatifs d'une même grandeur physique peut permettre de détecter une défaillance du capteur de courant 20, 20' principal et trouve donc sa place dans des dispositifs de mesure 10-13 pour lesquels la sécurité de fonctionnement est un critère important.

Ces différents exemples de réalisation montrent parfaitement bien la grande flexibilité d'utilisation de ce dispositif de mesure 10-13 ainsi que ses possibilités d'exploitation grâce notamment au câble de connexion 50 reliant les capteurs de courant 20, 20' et le capteur de tension auxiliaire 30 à l'unité de mesure 40 permettant de véhiculer des informations autres que les valeurs des grandeurs mesurées par lesdits capteurs, ces autres informations pouvant être infinies et utilisées pour assurer de multiples fonctions telles que la détection d'anomalie, de fraude et/ou de coupure, le contrôle, la surveillance, la sécurité, etc.

La présente invention n'est pas limitée aux exemples de réalisation décrits mais s'étend à toute modification et variante évidentes pour un homme du métier tout en restant dans l'étendue de la protection définie dans les revendications annexées.

## Revendications

1. Dispositif de mesure (10-13) d'au moins une grandeur physique d'une installation électrique, comportant au moins un capteur (20, 20') agencé pour mesurer au moins ladite grandeur physique et délivrer au moins un signal représentatif de ladite grandeur physique, et au moins une unité de mesure (40) agencée pour recevoir ledit signal et le traiter pour délivrer au moins une valeur de mesure exploitable, ledit capteur et ladite unité de mesure étant connectés entre eux par au moins un câble de connexion (50), ledit câble de connexion (50) comportant au moins trois paires de conducteurs, dont une première paire de conducteurs (51+, 51-), appelée paire de mesure (51), agencée pour transmettre ledit signal représentatif de ladite grandeur physique mesurée par ledit capteur (20, 20'), une deuxième paire de conducteurs (52+, 52-), appelée paire d'alimentation (52), agencée pour alimenter électriquement ledit capteur (20, 20') par ladite unité de mesure (40), et une troisième paire de conducteurs (53a, 53b), appelée paire de communication (53), agencée pour transmettre au moins un signal complémentaire (DET1, DET2) entre ledit capteur (20, 20') et ladite unité de mesure (40), ledit capteur (20, 20') comportant des moyens d'encodage (23, 24 ; 60) agencés pour caractériser ledit capteur et transmettre à ladite unité de mesure (40) via ladite paire de communication (53) au moins un signal complémentaire (DET1, DET2) correspondant à au moins une caractéristique d'identification dudit capteur, ladite unité de mesure (40) comportant en outre des moyens d'encodage (25, 26) complémentaires aux moyens d'encodage (23, 24, 60) prévus dans ledit capteur (20, 20'),
**caractérisé en ce que** ledit dispositif de mesure (10-13) est modulaire et adapté aussi bien à un capteur simple analogique (20) qu'à un capteur évolué numérique (20'), **en ce que** ladite unité de mesure (40) est conçue pour pouvoir être connectée à tout type de capteur (20, 20') et constitue un module standard, et **en ce que** ladite unité de mesure (40) comporte en outre une unité de traitement (45) intégrant un convertisseur analogique/numérique raccordé à ladite paire de communication (53) pour recevoir et traiter ledit au moins un signal complémentaire (DET1, DET2) transmis sur au moins un des conducteurs (53a, 53b) de ladite paire de communication (53), ce signal étant indifféremment un signal analogique ou un signal numérique et étant représentatif d'au moins une caractéristique d'identification dudit capteur permettant à ladite unité de mesure (40) de reconnaître automatiquement le capteur (20, 20') entre un capteur simple analogique (20) et un capteur évolué numérique (20') qui est branché à ladite unité de mesure (40), et de délivrer une valeur corrélée exploitable de ladite grandeur physique mesurée.

2. Dispositif de mesure selon la revendication 1, **caractérisé en ce que** ledit capteur (20) est analogique et comporte deux résistances (23, 24) dont les valeurs de résistance sont choisies en fonction d'au moins une caractéristique d'identification dudit capteur, et **en ce que** les moyens d'encodage de ladite unité de mesure (40) comporte deux autres résistances (25, 26) agencées pour former avec les deux résistances (23, 24) dudit capteur (20), deux ponts diviseurs de tension connectés d'une part à ladite paire d'alimentation (52) et d'autre part à ladite paire de communication (53) pour délivrer aux bornes de ladite paire de communication (53) à l'unité de traitement (45) de ladite unité de mesure (40) au moins un signal complémentaire (DET1, DET2) de tension sous forme analogique représentatif de ladite caractéristique d'identification dudit capteur (20).

3. Dispositif de mesure selon la revendication 1, **caractérisé en ce que** ledit capteur (20') est numérique et comporte une unité de traitement (60) dans laquelle est enregistrée au moins une caractéristique d'identification dudit capteur (20'), ladite unité de traitement étant connectée d'une part à ladite paire d'alimentation (52) et d'autre part à au moins un des conducteurs (53a) de la paire de communication (53) pour délivrer à l'unité de traitement (45) de ladite unité de mesure (40) au moins un signal complémentaire (DET1, DET2) sous forme numérique représentatif de ladite caractéristique d'identification dudit capteur (20').

4. Dispositif de mesure selon l'une quelconque des revendications précédentes, **caractérisé en ce que** lesdits moyens d'encodage (23, 24 ; 60) desdites capteurs (20, 20') sont agencés pour transmettre à l'unité de traitement (45) de ladite unité de mesure (40) via ladite paire de communication (53) plusieurs signaux complémentaires (DET1, DET2) correspondant à plusieurs caractéristique d'identification dudit capteur permettant à ladite unité de mesure (40) de reconnaître ledit capteur (20, 20') entre un capteur simple analogique (20) et un capteur évolué numérique (20'), lesdites caractéristiques d'identification dudit capteur (20, 20') étant choisies dans le groupe comprenant la tension nominale du capteur, le courant nominal du capteur, les données de calibrage du capteur, la courbe de compensation des erreurs de gain du capteur, la courbe de compensation des erreurs de phase du capteur.

5. Dispositif de mesure selon la revendication 1, **caractérisée en ce que** ladite unité de mesure (40) comporte deux résistances (41, 42) connectées respectivement entre les conducteurs (51+, 52+ ; 51-, 52-) desdites paires de mesure (51) et d'alimentation (52) pour polariser les conducteurs (51+, 51-) de ladite paire de mesure (51) et détecter la présence dudit capteur (20, 20').

6. Dispositif de mesure selon la revendication 1, **caractérisé en ce que** ladite paire de communication (53) est agencée pour véhiculer sur l'un de ses conducteurs (53a) au moins un premier signal complémentaire (DET1) représentatif d'au moins une caractéristique d'identification dudit capteur (20, 20') et sur l'autre de ses conducteurs (53b) au moins un second signal complémentaire (DET2) correspondant à une grandeur physique auxiliaire de ladite installation électrique.

7. Dispositif de mesure selon l'une quelconque des revendications précédentes, **caractérisé en ce que** ledit capteur (20, 20') est un capteur de courant agencé pour mesurer le courant sur un des conducteurs (L1) de ladite installation électrique.

8. Dispositif de mesure selon la revendication 7, **caractérisé en ce qu'**il comporte au moins un capteur de tension auxiliaire (30) agencé pour mesurer une valeur de tension auxiliaire représentative de la tension présente sur le conducteur (L1) dont on mesure le courant par ledit capteur de courant (20, 20'), cette valeur de tension auxiliaire formant une grandeur physique auxiliaire véhiculée sur un des conducteurs (53b) de ladite paire de communication (53).

9. Dispositif de mesure selon la revendication 8, **caractérisé en ce que** ledit capteur de tension auxiliaire (30) est intégré audit capteur de courant (20, 20').

10. Dispositif de mesure selon la revendication 8, **caractérisé en ce que** ledit capteur de tension auxiliaire (30) est monté en série entre ledit capteur de courant (20, 20') et ladite unité de mesure (40) et connecté à chacun d'eux par au moins un câble de connexion (50).

11. Dispositif de mesure selon la revendication 10, **caractérisé en ce que** ledit capteur de tension auxiliaire (30) comporte au moins un sélecteur (70) agencé pour inverser automatiquement le sens du branchement dudit capteur de tension auxiliaire (30) entre ledit capteur de courant (20, 20') et ladite unité de mesure (40) en cas d'erreur de branchement.

12. Dispositif de mesure selon la revendication 7, **caractérisé en ce que** ledit capteur de courant (20, 20') comporte au moins un capteur de courant de fuite à la terre à très basse fréquence par rapport à la fréquence du réseau alimentant ladite installation électrique, agencé pour mesurer une valeur de courant de fuite à la terre avec une bande passante incluant au moins la fréquence du réseau d'alimentation, cette valeur de courant de fuite à la terre formant une grandeur physique auxiliaire véhiculée sur un des conducteurs (53b) de ladite paire de communication (53).

13. Dispositif de mesure selon la revendication 7, **caractérisé en ce que** ledit capteur de courant (20, 20') comporte au moins un capteur de température agencé pour mesurer la température dudit capteur de courant, cette température formant une grandeur physique auxiliaire véhiculée sur un des conducteurs (53b) de ladite paire de communication (53).

14. Dispositif de mesure selon la revendication 7, **caractérisé en ce que** ledit capteur de courant (20, 20') comporte au moins un capteur de courant additionnel agencé pour effectuer une deuxième mesure de courant sur le conducteur (L1) de ladite installation électrique, cette deuxième mesure de courant formant une grandeur physique véhiculée sur un des conducteurs (53b) de ladite paire de communication (53) pour vérifier le bon fonctionnement dudit capteur de courant (20, 20') par comparaison de cette deuxième mesure de courant avec celle effectuée par ledit capteur de courant (20, 20').

15. Dispositif de mesure selon la revendication 1, **caractérisé en ce que** ladite unité de traitement (45) prévue dans l'unité de mesure (40) comporte au moins une table de correspondances entre des caractéristiques d'identification et des capteurs (20, 20').

16. Dispositif de mesure selon la revendication 8, **caractérisé en ce qu'**il comporte N capteurs de courant (20, 20'), pourvus chacun d'un capteur de tension auxiliaire (30), et N capteurs de tension (30') agencés pour mesurer respectivement le courant et la tension sur N conducteurs (L1, L2, L3) de ladite installation électrique, et **en ce que** ladite unité de mesure (40) comporte un module de corrélation agencé pour mettre en correspondance la mesure de tension (V1, V2, V3) qui correspond à la mesure de la tension auxiliaire (Vauxl,Vaux2,Vaux3) effectuée sur un même conducteur (L1, L2, L3) de ladite installation électrique et pallier automatiquement les éventuelles erreurs de branchement desdits capteurs (20, 20', 30').

17. Utilisation du dispositif de mesure (10-13) selon l'une quelconque des revendications précédentes pour détecter une tentative de fraude sur ledit dispositif de mesure (10-13) par détection d'une incohérence sur les signaux transmis via ledit câble de connexion (50) entre ledit capteur (20, 20') et ladite unité de mesure (40).

18. Utilisation du dispositif de mesure (10-13) selon la revendication 16 pour détecter l'ouverture d'un dispositif de coupure disposé en amont d'une installation électrique si d'une part ledit capteur de tension (30') est connecté en amont dudit dispositif de coupure et si d'autre part ledit capteur de courant (20') pourvu de son capteur de tension auxiliaire (30) est connecté en aval dudit dispositif de coupure.

## Patentansprüche

1. Vorrichtung zur Messung (10-13) mindestens einer physikalischen Größe einer elektrischen Installation, mit mindestens einem Sensor (20, 20'), vorgesehen zur Messung mindestens dieser physikalischen Größe und zur Lieferung mindestens eines für diese physikalische Größe repräsentativen Signals, und mindestens einer Messeinheit (40), die zum Empfang dieses Signals und zu seiner Verarbeitung zur Lieferung mindestens eines nutzbaren Messwertes vorgesehen ist, wobei dieser Sensor und diese Messeinheit miteinander durch mindestens ein Verbindungskabel (50) verbunden sind, wobei dieses Verbindungskabel (50) mindestens drei Leiterpaare enthält: das erste dieser Leiterpaare (51+, 51-), Messpaar (51) genannt, das zur Übertragung dieses für die genannte, von diesem Sensor (20, 20') gemessene physikalischen Größe repräsentativen Signals vorgesehen ist, ein zweites Leiterpaar (52+, 52-), Versorgungspaar (52) genannt, das für die Stromversorgung dieses Sensors (20, 20') über diese Messeinheit (40) vorgesehen ist, und ein drittes Leiterpaar (53a, 53b), Kommunikationspaar (53) genannt, das zur Übertragung mindestens eines komplementären Signals (DET1, DET2) zwischen diesem Sensor (20, 20') und dieser Messeinheit (40) vorgesehen ist, wobei dieser Sensor (20, 20') dabei Kodiermittel (23, 24; 60) enthält, die zur Charakterisierung dieses Sensors und zur Übertragung an die genannte Messeinheit (40) über das genannte Kommunikationspaar (53) mindestens eines komplementären Signals (DET1, DET2) vorgesehen ist, das mindestens ein Identifikationsmerkmal des genannten Sensors enthält, wobei diese Messeinheit (40) außerdem Kodiermittel (25, 26) enthält, die komplementär zu den Kodiermitteln (23, 24, 60) sind, die im genannten Sensor (20, 20') vorgesehen sind,
**dadurch gekennzeichnet, dass** die genannte Messvorrichtung (10-13) modular ist und sich sowohl für einen einfachen analogen Sensor (20) eignet, wie für einen entwickelten digitalen Sensor (20'), dadurch, dass die genannte Messeinheit (40) zur Verbindung mit jedem Sensortyp (20, 20') konzipiert ist und ein Standardmodul bildet, und dadurch, dass diese Messeinheit (40) außerdem eine Verarbeitungseinheit (45) enthält, in die ein Analog/ Digital-Wandler integriert ist, der mit diesem Kommunikationspaar (53) zum Empfang und der Verarbeitung dieses mindestens einen komplementären Signals (DET1, DET2) verbunden ist, das auf mindestens einen der Leiter (53a, 53b) dieses Kommunikationspaars (53) übertragen wird, wobei es sich bei diesem Signal dabei gleichermaßen um ein analoges oder ein digitales Signal handeln kann und es repräsentativ für mindestens ein Identifikationsmerkmal dieses Sensors ist, das es dieser Messeinheit (40) ermöglicht, bei der Erkennung des Sensors (20, 20') automatisch zwischen einem einfachen analogen Sensor (20) und einem entwickelten digitalen Sensor (20') zu unterscheiden, der an diese Messeinheit (40) angeschlossen ist und einen nutzbaren korrelierten Wert dieser gemessenen physikalischen Größe zu liefern.

2. Vorrichtung zur Messung nach Anspruch 1, **dadurch gekennzeichnet, dass** der genannte Sensor (20) analog ist und zwei Widerstände (23, 24) enthält, deren Widerstandwerte in Abhängigkeit von mindestens einem Identifikationsmerkmal dieses Sensors ausgewählt werden, und dadurch, dass die Kodiermittel dieser Messeinheit (40) zwei weitere Widerstände (25, 26) enthalten, die so ausgelegt sind, dass sie mit den beiden Widerständen (23, 24) des genannten Sensors (20) zwei Spannungsteiler bilden, die einerseits an das genannte Versorgungspaar (52) und andererseits an das genannte Kommunikationspaar (53) angeschlossen sind, um an die Klemmen dieses Kommunikationspaares (53) an der Verarbeitungseinheit (45) dieser Messeinheit (40) mindestens ein komplementäres Spannungssignal (DET1, DET2) in analoger Form zu liefern, das repräsentativ für dieses Identifikationsmerkmal dieses Sensors (20) ist.

3. Vorrichtung zur Messung nach Anspruch 1, **dadurch gekennzeichnet, dass** der genannte Sensor (20') digital ist und eine Verarbeitungseinheit (60) enthält, in der mindestens ein Identifikationsmerkmal dieses Sensors (20') enthalten ist, wobei diese Verarbeitungseinheit dabei einerseits an das genannte Versorgungspaar (52) und andererseits an mindestens einen der Leiter (53a) des Kommunikationspaars (53) angeschlossen ist, um an die Verarbeitungseinheit (45) der genannten Messeinheit (40) mindestens ein komplementäres Signal (DET1, DET2) in digitaler Form zu liefern, das für dieses Identifikationsmerkmal dieses Sensors (20') repräsentativ ist.

4. Vorrichtung zur Messung nach einem der vorangehenden Ansprüche, **dadurch gekennzeichnet, dass** die genannten Kodiermittel (23, 24 ; 60) der genannten Sensoren (20, 20') dazu vorgesehen sind, an die Verarbeitungseinheit (45) der genannten Messeinheit (40) über das genannte Kommunikationspaar (53) verschiedene komplementäre Signale (DET1, DET2) zu übertragen, die verschiedenen Identifikationsmerkmalen dieses Sensors entsprechen, die es dieser Messeinheit (40) ermöglichen, bei der Erkennung dieses Sensors (20, 20') zwischen einem einfachen analogen Sensor (20) und einem entwickelten digitalen Sensor (20') zu unterscheiden, wobei diese Identifikationsmerkmale dieses Sensors (20, 20') dabei aus der Gruppe mit der Nennspannung des Sensors, dem Nennstrom des Sensors, den Kalibrierungsdaten des Sensors, der Kompensationskurve der Verstärkungsfehler des Sensors und der Kompensationskurve der Phasenfehler des Sensors ausgewählt werden.

5. Vorrichtung zur Messung nach Anspruch 1, **dadurch gekennzeichnet, dass** die genannte Messeinheit (40) zwei Widerstände (41, 42) enthält, die jeweils zwischen den Leitern (51+, 52+ ; 51-, 52-) dieser Mess- (51) und Versorgungspaare (52) verbunden sind, um die Leiter (51+, 51-) dieses Messpaars (51) zu polarisieren und das Vorhandensein dieses Sensors (20, 20') zu erkennen.

6. Vorrichtung zur Messung nach Anspruch 1, **dadurch gekennzeichnet, dass** das genannte Kommunikationspaar (53) vorgesehen ist, um auf einem seiner Leiter (53a) mindestens ein erstes komplementäres Signal (DET1) zu transportieren, das für mindestens ein Identifikationsmerkmal dieses Sensors (20, 20') repräsentativ ist, und auf dem anderen seiner Leiter (53b) mindestens ein zweites komplementäres Signal (DET2) entsprechend einer physikalischen Hilfsgröße dieser elektrischen Installation.

7. Vorrichtung zur Messung nach einem der vorangehenden Ansprüche, **dadurch gekennzeichnet, dass** es sich bei dem genannten Sensor (20, 20') um einen Stromsensor handelt, der dazu vorgesehen ist, um den Strom auf einem der Leiter (L1) dieser elektrischen Installation zu messen.

8. Vorrichtung zur Messung nach Anspruch 7, **dadurch gekennzeichnet, dass** sie mindestens einen Hilfsspannungssensor (30) enthält, der vorgesehen ist, um einen Hilfsspannungswert zu messen, der für die im Leiter (L1) vorhandene Spannung repräsentativ ist, dessen Strom durch den genannten Stromsensor (20, 20') gemessen wird, wobei dieser Hilfsspannungswert eine physikalische Hilfsgröße bildet, die über einen der Leiter (53b) dieses Kommunikationspaars (53) transportiert wird.

9. Vorrichtung zur Messung nach Anspruch 8, **dadurch gekennzeichnet, dass** der genannte Hilfsspannungssensor (30) in den genannten Stromsensor (20, 20') integriert ist.

10. Vorrichtung zur Messung nach Anspruch 8, **dadurch gekennzeichnet, dass** der genannte Hilfsspannungssensor (30) in Reihe zwischen diesem Stromsensor (20, 20') und dieser Messeinheit (40) montiert ist und mit jedem von ihnen über mindestens ein Verbindungskabel (50) verbunden ist.

11. Vorrichtung zur Messung nach Anspruch 10, **dadurch gekennzeichnet, dass** der genannte Hilfsspannungssensor (30) mindestens einen Wahlschalter (70) enthält, der vorgesehen ist, um automatisch die Anschlussrichtung des genannten Hilfsspannungssensors (30) zwischen dem genannten Stromsensor (20, 20') und der genannten Messeinheit (40) bei einem Anschlussfehler umzukehren.

12. Vorrichtung zur Messung nach Anspruch 7, **dadurch gekennzeichnet, dass** dieser Stromsensor (20, 20') mindestens einen Erdschlusssensor, mit sehr niedriger Frequenz, bezogen auf die Frequenz des Netzes zur Versorgung der genannten elektrischen Installation enthält, der zur Messung eines Erdschlussstromwertes mit einer Bandbreite vorgesehen ist, die mindestens die Frequenz des Versorgungsnetzes beinhaltet, wobei dieser Erdschlussstromwert eine physikalische Hilfsgröße bildet, die über einen der Leiter (53b) des genannten Kommunikationspaares (53) transportiert wird.

13. Vorrichtung zur Messung nach Anspruch 7, **dadurch gekennzeichnet, dass** der genannte Stromsensor (20, 20') mindestens einen Temperatursensor enthält, der vorgesehen ist, um die Temperatur dieses Stromsensors zu messen, wobei diese Temperatur eine physikalische Hilfsgröße bildet, die über einen der Leiter (53b) des genannten Kommunikationspaares (53) transportiert wird.

14. Vorrichtung zur Messung nach Anspruch 7, **dadurch gekennzeichnet, dass** der genannte Stromsensor (20, 20') mindestens einen zusätzlichen Stromsensor enthält, der vorgesehen ist, um eine zweite Strommessung am Leiter (L1) dieser elektrischen Installation durchzuführen, wobei diese zweite Strommessung eine physikalische Größe bildet, die über einen der Leiter (53b) des genannten Kommunikationspaares (53) transportiert wird, um das einwandfreie Funktionieren dieses Stromsensors (20, 20') durch Vergleich dieser zweiten Strommessung mit derjenigen, die vom genannten Stromsensor (20, 20') ausgeführt wird, zu überprüfen.

15. Vorrichtung zur Messung nach Anspruch 1, **dadurch gekennzeichnet, dass** die genannte in der Messeinheit (40) vorgesehene Verarbeitungseinheit (45) mindestens eine Entsprechungstabelle zwischen Identifikationsmerkmalen und Sensoren (20, 20') enthält.

16. Vorrichtung zur Messung nach Anspruch 8, **dadurch gekennzeichnet, dass** sie N Stromsensoren (20, 20'), von denen jeder mit einem Hilfsspannungssensor (30) ausgerüstet ist, sowie N Spannungssensoren (30') enthält, die vorgesehen sind, um jeweils den Strom und die Spannung an N Leitern (L1, L2, L3) dieser elektrischen Installation zu messen und dadurch, dass diese Messeinheit (40) ein Korrelationsmodul enthält, das vorgesehen ist, um die Spannungsmessung (VI, V2, V3), die der Messung der Hilfsspannung (Vaux1,Vaux2,Vaux3) entspricht, die am selben Leiter (L1, L2, L3) dieser elektrischen Installation durchgeführt wurde, in Übereinstimmung zu bringen und automatisch eventuelle Anschlussfehler dieser Sensoren (20, 20', 30') auszugleichen.

17. Einsatz der Messvorrichtung (10-13) nach einem der vorangehenden Ansprüche, um durch Erkennen einer Inkohärenz der über dieses Verbindungskabel (50) zwischen diesem Sensor (20, 20') und dieser Messeinheit (40) übertragenen Signale einen Betrugsversuch an dieser Messvorrichtung (10-13) zu erkennen.

18. Einsatz der Messvorrichtung (10-13) nach Anspruch 16, um zu erkennen, dass eine Abschaltvorrichtung, die vor einer elektrischen Installation angeordnet ist, geöffnet wurde, wenn einerseits dieser Spannungssensor (30') vor dieser Abschaltvorrichtung angeschlossen ist und wenn andererseits dieser Stromsensor (20'), der mit seinem Hilfsspannungssensor (30) versehen ist, hinter dieser Abschaltvorrichtung angeschlossen ist.

## Claims

1. Device (10-13) for measuring at least one physical quantity of an electric installation, comprising at least one sensor (20, 20') arranged to measure at least the said physical quantity and to deliver at least one signal representative of the said physical quantity, and at least one measuring unit (40) arranged to receive the said signal and process it to deliver at least one usable measured value, the said sensor and the said measuring unit being connected to each other by at least one connecting cable (50), the said connecting cable (50) comprising at least three conductor pairs, a first conductor pair (51+, 51-), called measuring pair (51), arranged to transmit said signal representative of the said physical quantity measured by the said sensor (20, 20'), a second pair of conductors (52+, 52-), called power supply pair (52), arranged to supply power to the said sensor (20), 20') by the said measuring unit (40), and a third pair of conductors (53a, 53b), called communication pair (53), arranged to transmit at least one complementary signal (DET1, DET2) between the said sensor (20, 20') and the said measuring unit (40), the said sensor (20, 20') comprising encoding means (23, 24; 60) arranged to characterize the said sensor and transmit to the said measuring unit (40) via the said communication pair (53) at least one complementary signal (DET1, DET2) corresponding to at least one identification characteristic of the said sensor, the said measuring unit (40) comprising in addition encoding means (25, 26) complementary to the encoding means (23, 24, 60) provided in the said sensor (20, 20'),
**characterized in that** the said measuring unit (10-13) is modular and adaptable both to a simple analog sensor (20) and to an advanced digital sensor (20'), **in that** said measuring unit (40) is designed to be connectable to any type of sensor (20, 20') and constitutes a standard module, and **in that** the said measuring unit (40) further comprises a processing unit (45) incorporating an analog/digital converter connected to said communication pair (53) for receiving and processing said at least one complementary signal (DET1, DET2) transmitted on at least one of the conductors (53a, 53b) of said communication pair (53), this signal being indifferently an analog signal or a digital signal and being representative of at least one identification characteristic of said sensor allowing said measuring unit (40) to automatically recognize the sensor (20, 20') between a simple analog sensor (20) and an advanced digital sensor (20') which is connected to said measuring unit (40), and to deliver a correlated usable value of said measured physical quantity.

2. Measuring device according to claim 1, **characterized in that** said sensor (20) is analog and comprises two resistors (23, 24) whose resistance values are chosen as a function of at least one identification characteristic of said sensor, and **in that** the encoding means of said measuring unit (40) comprises two other resistors (25, 26) arranged to form with the two resistors (23, 24) of said sensor (20), two voltage divider bridges connected on the one hand to said supply pair (52) and on the other hand to said communication pair (53) in order to deliver at the terminals of said communication pair (53) to the processing unit (45) of said measuring unit (40) at least one complementary voltage signal (DET1, DET2) in analog form representative of said identification characteristic of said sensor (20).

3. Measuring device according to claim 1, **characterized in that** said sensor (20') is digital and comprises a processing unit (60) in which at least one identification characteristic of said sensor (20') is recorded, said processing unit being connected on the one hand to said power supply pair (52) and on the other hand to at least one of the conductors (53a) of the communication pair (53) in order to deliver to the processing unit (45) of said measuring unit (40) at least one additional signal (DET1, DET2) in digital form representative of said identification characteristic of said sensor (20').

4. Measuring device according to any one of the preceding claims, **characterized in that** said encoding means (23, 24; 60) of said sensors (20, 20') are arranged to transmit to the processing unit (45) of said measuring unit (40) via said communication pair (53) a plurality of complementary signals (DET1, DET2) corresponding to a plurality of identification characteristics of said sensor enabling said measuring unit (40) to recognize said sensor (20, 20') between a single analog sensor (20) and an advanced digital sensor (20'), said identification characteristics of said sensor (20, 20') being selected from the group comprising the nominal voltage of the sensor, the nominal current of the sensor, the calibration data of the sensor, the compensation curve for the gain errors of the sensor, the compensation curve for the phase errors of the sensor.

5. Measuring device according to claim 1, **characterized in that** said measuring unit (40) comprises two resistors (41, 42) connected respectively between the conductors (51+, 52+; 51-, 52-) of said measuring (51) and supply (52) pairs for polarizing the conductors (51+, 51-) of said measuring pair (51) and detecting the presence of said sensor (20, 20').

6. Measuring device according to claim 1, **characterized in that** said communication pair (53) is arranged to carry on one of its conductors (53a) at least one first complementary signal (DET1) representing at least one identification characteristic of said sensor (20, 20') and on the other of its conductors (53b) at least one second complementary signal (DET2) corresponding to an auxiliary physical quantity of said electrical installation.

7. Measuring device according to any of the preceding claims, **characterized in that** said sensor (20, 20') is a current sensor arranged to measure the current on one of the conductors (L1) of said electrical installation.

8. Measuring device according to claim 7, **characterized in that** it comprises at least one auxiliary voltage sensor (30) arranged to measure an auxiliary voltage value representing the voltage present on the conductor (LI) whose current is measured by said current sensor (20, 20'), this auxiliary voltage value forming an auxiliary physical quantity carried on one of the conductors (53b) of said communication pair (53).

9. Measuring device according to claim 8, **characterized in that** said auxiliary voltage sensor (30) is integrated with said current sensor (20, 20').

10. Measuring device according to claim 8, **characterized in that** said auxiliary voltage sensor (30) is connected in series between said current sensor (20, 20') and said measuring unit (40) and connected to each of them by at least one connecting cable (50).

11. Measuring device according to claim 10, **characterized in that** said auxiliary voltage sensor (30) comprises at least one selector (70) arranged to automatically reverse the direction of connection of said auxiliary voltage sensor (30) between said current sensor (20, 20') and said measuring unit (40) in the event of a connection error.

12. Measuring device according to claim 7, **characterized in that** said current sensor (20, 20') comprises at least one earth leakage current sensor with a very low frequency relative to the frequency of the network supplying said electrical installation, arranged to measure an earth leakage current value with a bandwidth including at least the frequency of the supply network, this earth leakage current value forming an auxiliary physical quantity conveyed on one of the conductors (53b) of said communication pair (53).

13. Measuring device according to claim 7, **characterized in that** said current sensor (20, 20') comprises at least one temperature sensor arranged to measure the temperature of said current sensor, this temperature forming an auxiliary physical quantity carried on one of the conductors (53b) of said communication pair (53).

14. Measuring device according to claim 7, **characterized in that** said current sensor (20, 20') comprises at least one additional current sensor arranged to carry out a second current measurement on the conductor (L1) of said electrical installation, this second current measurement forming a physical quantity conveyed on one of the conductors (53b) of said communication pair (53) in order to check the correct operation of said current sensor (20, 20') by comparing this second current measurement with that carried out by said current sensor (20, 20').

15. Measuring device according to claim 1, **characterized in that** said processing unit (45) provided in the measuring unit (40) comprises at least one table of correspondences between identification characteristics and sensors (20, 20').

16. Measuring device according to claim 8, **characterized in that** it comprises N current sensors (20, 20'), each provided with an auxiliary voltage sensor (30), and N voltage sensors (30') arranged to measure respectively the current and the voltage on N conductors (L1, L2, L3) of said electrical installation, and **in that** said measuring unit (40) comprises a correlation module arranged to correlate the voltage measurement (V1, V2, V3) corresponding to the measurement of the auxiliary voltage (Vaux1, Vaux2, Vaux3) carried out on the same conductor (L1, L2, L3) of said electrical installation and to automatically compensate for possible connection errors of said sensors (20, 20', 30').

17. Use of the measuring device (10-13) according to any of the preceding claims for detecting an attempt of fraud on said measuring device (10-13) by detecting an inconsistency in the signals transmitted via said connecting cable (50) between said sensor (20, 20') and said measuring unit (40).

18. Use of the measuring device (10-13) according to claim 16 for detecting the opening of a disconnection device arranged upstream of an electrical installation if, on the one hand, the voltage sensor (30') is connected upstream of the disconnection device and if, on the other hand, the current sensor (20') provided with its auxiliary voltage sensor (30) is connected downstream of the disconnection device.
